# EUROPEAN PATENT APPLICATION

(11) **EP 4 099 031 A1**
(43) Date of publication of application: **07.12.2022**
(21) Application number: 21177271.0
(22) Date of filing: 01.06.2021
(51) Int. Cl.: G01R 31/26, G01K 7/42

(54) **METHOD FOR MONITORING AN ELECTRICAL OR ELECTRONIC SYSTEM AND A FURTHER SYSTEM CONFIGURED TO PERFORM THE METHOD**

(71) Applicant: Maschinenfabrik Reinhausen GmbH, 93059 Regensburg (DE)
(72) Inventor: BRYANT, Angus, Cambridge, CB24 3AU (GB)

(57) **Abstract**

The present invention relates to a method and a corresponding system for monitoring an electrical or electronic system, wherein an preferably not measurable characteristic variable of the electrical or electronic system is estimated with an adjusted thermal and/or electrical model of the electrical or electronic system.

## Description

The invention relates to a method for monitoring an electric or electronic system and a further system configured to perform the method.

Electrical or electronic systems may be characterized by characteristic variables during their operation. These characteristic variables may represent quantitatively determinable, technical properties of the electrical or electronic system. For example, the characteristic variables may relate to an electric current, an electric voltage, a temperature, an electric or thermal power, or other technical properties of the system.

In practice, electrical or electronic systems are often subject to a complex structure or a high integration density, so that states or processes within the system are not always measurable from the outside. At the same time, however, these non-measurable states or processes of the system can be of interest to derive reliability, aging state, or other properties that affect the system.

For example, a core temperature at the center of the electrical or electronic system may be of interest to monitor the electrical and/or thermal stress on the system during operation and/or to estimate an aging condition of the system. In many cases, the core temperature at the center of the electrical or electronic system cannot be measured or can only be measured at considerable expense. However, even if the core temperature of the electrical or electronic system should be measurable, the system behavior or temperature response is often disturbed by the measurement process. If the core temperature is not measurable, the use of an externally measurable temperature of the electrical or electronic system in combination with a mathematical model representing the system has proven to be an alternative, but the core temperature often cannot be determined with sufficient precision in this way.

The invention is therefore based on the problem of providing an improved method and an associated, improved system that enables technical variables of an electrical or electronic system to be monitored as precisely as possible.

According to a first aspect of the present invention, the problem is solved by a method according to claim 1. Therefore, a method for monitoring an electrical or electronic system is provided, wherein the method comprising at least the following steps a) to g):
a) measuring at least one characteristic variable of the system during operation of the system, wherein the at least one characteristic variable of the system includes a voltage drop, in particular an on-state voltage drop or a gate-source voltage drop, across two nodes of the system being connected directly or indirectly to a semiconductor device of the system;
b) estimating a thermal variable of the system with a thermal model of the system executed by a processing unit and based on at least one measured variable of step a);
c) estimating a model-voltage drop, in particular an on-state model-voltage drop or a gate-source model-voltage drop, as an estimation for the measured voltage drop of step a) with an electrical model of the system executed by the processing unit and based at least on the estimated thermal variable of step b);
d) comparing the measured voltage drop of step a) with the estimated model-voltage drop of step c);
e) adjusting at least one model parameter of the thermal model based on the result of step d);
f) adjusting at least one model parameter of the electrical model based on the result of step d); and
g) estimating a characteristic variable not measured in step a) as an estimation of a physical variable of the system during operation with the adjusted, thermal and/or electrical model executed by the processing unit and based on the result of at least one of the steps a) to d).

In principle, it is preferred that steps a) to g) are carried out sequentially. However, this sequential execution of the steps is not necessary in every case. For example, steps e) and f) may be executed in parallel or at least partially overlapping in time.

The voltage drop measured in step a) is, for example, the on-state voltage drop or the gate-source voltage drop. The measured voltage drop is explained below in connection with the on-state voltage drop, but the measured voltage drop is preferably not intended to be limited to the on-state voltage drop. The technical explanations, preferred features, technical effects or advantages given in connection with the on-state voltage drop as a preferred embodiment of the voltage drop measured in step a) may apply in an analogous manner to any further preferred embodiment of the voltage drop measured in step a), such as the measured gate-source voltage drop. Preferably, however, the voltage drop measured in step a) is assumed to be defined by the on-state voltage drop.

The model voltage drop estimated in step c) may be defined, for example, by an estimated voltage for the on-state voltage drop measured in step a) or by an estimated voltage for the gate-source voltage drop measured in step a). The estimated model voltage drop is explained below in connection with the estimated model on-state voltage drop, but the estimated model voltage drop is preferably not intended to be limited to the estimated model on-state voltage drop. The technical explanations, preferred features, technical effects or advantages provided in connection with the on-state voltage drop as a preferred embodiment of the model voltage drop estimated in step c) may apply in an analogous manner to any further advantageous embodiment of the model voltage drop estimated in step c), such as the estimated model gate-source voltage drop. Preferably, however, the model voltage drop estimated in step c) is assumed to be defined by the estimated model gate-source voltage drop.

Before the individual steps and the associated features are discussed in further detail, the concept underlying the first aspect of the invention will first be explained.

In practical investigations of electrical or electronic systems, it has been found that in such a system a temperature of the system can be measured from the outside, but that an electrical or electronic system usually comprises at least one semiconductor device, wherein a on-state voltage drop between two electrical nodes of the system, which are directly or indirectly connected to the semiconductor device, can be measured from the outside. The on-state voltage drop is thus a measurable, electrical voltage. The on-state voltage drop is also precisely measurable and is often subject to no or at most a very small time delay. In addition, the on-state voltage drop may be detected without significant technical effort.

Against the background that the on-state voltage drop is externally measurable particularly precisely and with at most a small time delay for a semiconductor component of an electrical or electronic system, the on-state voltage drop offers a particularly advantageous technically quantifiable characteristic variable of the electrical or electronic system in order to adapt an electrical model as well as a thermal model for the system based on the measured on-state voltage drop. At least one of these two models maybe used, after the appropriate adjustment, to determine another characteristic variable of the electrical or electronic system. This other characteristic variable may represent, for example, a non-measurable, technically quantifiable property of the electrical or electronic system. Alternatively, it is possible that the aforementioned other characteristic variable represents a measurable, technically quantifiable property of the electrical electronic system, but which is not measured in practice or is measurable only with significant effort.

The method according to the first aspect of the invention thus offers the advantage that an often simply measurable on-state voltage drop of an electrical or electronic system can be used to estimate other characteristic variables of the electrical or electronic system simply and at the same time precisely using a previously adapted electrical and/or thermal model.

According to step a), at least one characteristic variable of the electrical or electronic system is measured during operation of this system. Nevertheless, more than one characteristic variable of the electrical or electronic system may be measured in step a). However, at least one of the at least one measured characteristic variable is the voltage drop, preferrable the on-state voltage drop between two nodes of the electrical or electronic system, the two nodes being directly or indirectly connected to a semiconductor device of the system. The measurement of the at least one characteristic variable is preferably performed with a sensor. For each characteristic variable, an associated sensor may be used. However, it is also possible for one sensor to simultaneously measure multiple characteristic variables of the electrical or electronic system.

For example, the on-state voltage drop measured in step a) may drop between two nodes directly on the semiconductor device of the electrical or electronic system and be measured directly by the at least one sensor. However, it is also possible that the on-state voltage drop of the semiconductor device is transmitted via further electrical components of the electrical or electronic system to the two nodes of the electrical or electronic system, where the on-state voltage drop is then measured indirectly, preferably by means of a sensor.

The on-state voltage drop is often present in semiconductor switches, such as a transistor. In order to turn a transistor into an on-state, a voltage needs to be applied to the transistor that is greater than its on-state voltage. In response, the transistor may produce an on-state voltage drop, also referred to as a forward on-state voltage drop. The on-state voltage drop is usually in the direction of the applied voltage. The on-state voltage drop often indicates an energy dissipation of the transistor during its on-stage.

In step b), a thermal model of the electrical or electronic system is executed by means of a processing unit. The thermal model is preferably based on a mathematical model that represents at least a part of the thermal system behavior of the electrical or electronic system. The thermal model may be predetermined and/or adjustable by changes of its model parameters. For example, the thermal system behavior may be represented by the thermal model as a function of the at least one characteristic variable measured in step a). When executing the thermal model, the at least one measured characteristic variable, or a sub-set thereof, may be considered as an input variable for the thermal model. For instance, the thermal model may represent the thermal system behavior as a function of the measured on-state voltage drop. If further characteristic variables of the system are measured in step a), these can be considered for the representation of the thermal system behavior.

The thermal variable determined with the thermal model often has a small error compared to the corresponding actual thermal variable of the electrical or electronic system, so that in step b) it is referred to as an estimate. The thermal variable determined in step b) is therefore also referred to as an estimated thermal variable.

For a semiconductor device, the associated on-state voltage drop often depends on a thermal variable of the system, such as the temperature of the semiconductor device or an ambient temperature of components of the system surrounding the semiconductor device.

In step c), an electrical model of the electrical or electronic system is executed using the processing unit. The electrical model is preferably a mathematical model representing the electrical system behavior of the electrical or electronic system. The electrical model may be predetermined and adjustable by changes of its model parameters. The electrical system behavior may depend on at least one thermal variable, such as a temperature of the electrical or electronic system. When executing the electrical model, the at least one thermal variable may be considered as an input variable for the electrical model. Therefore, it is provided in step c) that an estimated value of the voltage drop, preferably the on-state voltage drop of the semiconductor device of the electrical or electronic system is determined directly or indirectly by executing the electrical model. This on-state voltage drop determined using the electrical model often has a small error with respect to the actual on-state voltage drop, so that in step c), the on-state voltage drop is referred to as an estimate. The on-state voltage drop determined in step c) is also referred to as the estimated on-state voltage drop.

Preferably, the estimated on-state model-voltage drop of step c) is an estimate for the measured on-state voltage drop across two nodes of the system being connected directly or indirectly to a semiconductor device of the system as defined in step a).

In step d), the voltage drop, preferably the on-state voltage drop measured in step a) is compared with the voltage drop, preferably the on-state voltage drop estimated in step c). The comparison is preferably performed by the processor unit. The comparison may, for example, be performed by calculating the difference between the measured on-state voltage drop and the estimated on-state voltage drop. Thus, for example, the processor unit may determine the difference between the two on-state voltage drops. However, comparison by difference is only one possible example. Another comparison may be performed, for example, by calculating a quotient between the measured on-state voltage drop and the estimated on-state voltage drop. Other functions that relate the measured on-state voltage drop to the estimated on-state voltage drop are also possible. The result of the comparison performed in step d) is also referred to as the comparison result. For example, the comparison result indicates the error between the estimated on-state voltage drop and the measured on-state voltage drop. If the error is small, the correspondingly small comparison result indicates that a particularly precise estimate of the on-state voltage drop was made in step c). In this case, the comparison result may further indicate that the electrical model represents the electrical characteristics of the electrical or electronic system particularly accurately.

If the error between the measured on-state voltage drop and the estimated on-state voltage drop is large, where the corresponding error is indicated by the comparison result, the corresponding result from step d) may be used to adjust and thereby improve the thermal model of the electrical or electronic system and/or to adjust the electrical model of the electrical or electronic system. The goal of this adjustment is preferably that the electrical model and/or the thermal model better represents the electrical or electronic system, so that the error between the measured on-state voltage drop and the estimated on-state voltage drop becomes smaller. The smaller error is then also seen when step d) is executed again.

In step e), at least one model parameter of the thermal model is adjusted based on the result from step d). The adjustment of the at least one model parameter of the thermal model is preferably performed by the processing unit. In other words, step e) is preferably carried out by the processing unit. Thermal characteristics of the electrical or electronic system may influence the on-state voltage drop. For example, the on-state voltage drop may be different for different core temperatures of the electrical or electronic system. The result from step d) can therefore be used to better fit the thermal model to the actual thermal characteristics of the electrical or electronic system. It is preferable that only the at least one model parameter of the thermal model is adjusted.

Preferably, the thermal model of the electrical or electronic system is coupled to the electrical model of the electrical or electronic system. Thus, an input variable of the electrical model may be determined by an output variable of the thermal model. Preferably, the aforementioned input variable and the aforementioned output variable will be present when the thermal model and the electrical model are executed. Both models can be executed with the processing unit. If the thermal model is adjusted, as previously explained, based on the result of step d) so that the thermal model more accurately represents the thermal characteristics of the electrical or electronic system, an output variable of the electrical model will also be more accurately represent an actual, electrical quantity or electrical characteristic of the electrical or electronic model. Therefore, by adjusting the at least one model parameter of the thermal model based on the result of step d), it is possible, for example, that the comparison result will be better when step d) is performed again.

In step f), at least one model parameter of the electrical model is adjusted based on the result from step d). The adjustment of the at least one model parameter of the electrical model is preferably performed by the processing unit. In other words, step e) is preferably carried out by the processing unit. Electrical characteristics of the electrical or electronic system may influence the on-state voltage drop. For example, the on-state voltage drop may be different for different core temperatures of the electrical or electronic system. The result from step d) can therefore be used to better fit the electrical model to the actual electrical characteristics of the electrical or electronic system. It is preferable that only the at least one model parameter of the electrical model is adjusted.

In step g), the thermal model previously adjusted in step b) and/or the electrical model previously adjusted in step f) is executed by the processing unit to determine a characteristic variable (not measured in step a)) as an estimate for a physical variable of the electrical or electronic system. The characteristic variable determined in this way usually has an error with respect to the actual value of the physical variable for which the characteristic variable forms an estimate. The determination of the characteristic variable in step g) is therefore also referred to as an estimation.

For the determination of the characteristic variable in step g) at least one result of steps a), b) and/or c) is considered. For example, a characteristic variable of the electrical and electronic system measured in step a) may be used as an input variable for the adjusted, thermal model or for the adjusted, electrical model during the execution of the respective model by means of the processing unit. In step a), at least the on-state voltage drop is measured as the characteristic variable. However, it is also possible that in step a) at least one further characteristic variable of the electrical and electronic system is measured. This at least one further characteristic variable can be used in step g) to form an input variable for the adjusted thermal model or for the adjusted electrical model. If, for example, an on-state current of a semiconductor component of the electrical or electronic system is measured as a further characteristic variable in step a) and is used in step g) as a direct or indirect input variable for the adjusted thermal model when this is executed by the processor unit, a further characteristic variable of the electrical or electronic system, in particular a thermal variable of the electrical and electronic system, which was not previously measured in step a), can be determined by means of the adjusted thermal model by execution by means of the processor unit.

The determination or estimation of the characteristic variable in step g) offers the advantage that this characteristic variable is an estimate for an actual physical variable of the electrical or electronic system, where the actual physical variable may not be measurable in practice or may only be measurable with a considerable effort and/or a considerable error. In other words, the characteristic variable determined or estimated in step g) can particularly easily and at the same time accurately represent the estimated value of a physical variable of the system that is not measurable or is difficult to measure. The variable determined or estimated in step g) may be used to monitor the electrical or electronic system. For example, the processing unit may be configured to compare the characteristic variable determined or estimated in step g) to a threshold value and trigger a fault condition if the threshold value is exceeded. However, it is also possible that the characteristic variable determined or estimated in step g) is forwarded, for example to a higher-level system in which the determined or estimated variable from step g) is processed further, in particular for monitoring and/or error evaluation.

Preferably, each of the steps b) to g) is performed by the same processing unit. The processing unit may be a part of the electric or electronic system. However, the processing unit may alternatively be separate to the electric or electronic system.

Preferably, step a) may be performed by a measurement unit. The measurement unit may be a part of the electric or electronic system. However, the measurement unit may alternatively be separate to the electric or electronic system.

According to a preferred embodiment of the method according to the first aspect of the present invention, the semiconductor device of step a) is a transistor, a diode, or a thyristor. Preferably, the transistor is a MOSFET-Transistor, a bipolar transistor or a combination thereof, for instance an IGBT. The semiconductor device may be a switched semiconductor device or a non-switched semiconductor device. The semiconductor device may (alternatively) be a diode, a thyristor, in particular an IGCT or a HEMT-type device (preferably designed as a GaN FET).

According to a further preferred embodiment of the method according to the first aspect of the present invention, wherein a first group of steps includes steps a) to d) and e) and/or f) of claim 1, wherein the first group is repeated one after the other, wherein the parameters of the thermal and electrical model are set by predetermined parameters at the first execution of the first group, and wherein the parameters of the thermal and electrical model are set by the parameters adjusted in the previous execution of the first group at a repetition of the first group. The first group of steps may be formed by on of the following alternative groups (i) to (iii) of steps: (i) steps a) to e), (ii) steps a) to d) and f), or (iii) steps a) to f).

The repetition of the first group of steps is also referred to as repeating the first group of steps in groups. Once the execution of the first group of the steps is complete, this first group of the steps can be executed again. This may take place repeatedly, such that the first group of the steps may be repeatedly executed multiple times sequentially. Each time the first group of steps is executed, the associated steps of this first group are preferably executed sequentially. This is at least preferably true for alternative (i) and (ii). In alternative (iii), the first group of steps may comprise both step e) and step f), which may be executed sequentially in time, partially overlapping in time, or completely in parallel in time. Preferably, the repetition of the first group does not alternate between alternatives (i) through (iii).

The number of repetitions of the first group may be a predetermined number. However, it is also possible that the repetition of the first group is completed when a result of step d) reaches a predetermined threshold value. For example, if the comparison result according to step d) is small enough to correspond to a predetermined threshold value, the respective first group can still be executed to the end. If the respective first group does not include step e) or step f), this missing step is preferably executed after the termination of the repetition of the first group. In addition, after the repetition of the first group has ended, step g) is executed at least once. Overall, it can thus be ensured that all steps a) to g) are executed at least once as is required in accordance with the first aspect of the invention, even if the first group of steps is repeated. The repetition of the first group of steps according to alternative (i) offers the advantage that, for example, the thermal model is improved first before steps f) and g) are carried out subsequently.

The repetition of the first group of steps according to alternative (ii) offers the advantage that, for example, the electrical model is improved first, before steps e) and g) are carried out subsequently.

The repetition of the first group of steps according to alternative (iii) offers the advantage that both the electrical model and the thermal model are improved with each repetition, and that subsequently step g) is executed at least once.

All three alternatives also offer the advantage that step g) is executed, for example, only after the repetition of the first group of steps, so that the characteristic variable determined or estimated in step g) is particularly precise.

According to a second aspect of the present invention, the problem outlined in the introduction is solved by a method according to claim 4. Therefore, a method for monitoring an electrical or electronic system is provided, wherein the method comprising at least the following steps A) to F):
A) measuring at least one characteristic variable of the system during operation of the system, wherein the at least one characteristic variable of the system includes a voltage drop, in particular an on-state voltage drop or a gate-source voltage drop, across two nodes of the system being connected directly or indirectly to a semiconductor device of the system;
B) estimating a thermal variable of the system with a thermal model of the system executed by a processing unit and based at least one measured variable of step A);
C) estimating a model-voltage drop, in particular an on-state model-voltage drop or a gate-source model-voltage drop, as an estimation for the measured voltage drop of step A) with an electrical model of the system executed by the processing unit and based at least on the estimated thermal variable of step B);
D) comparing the measured voltage drop of step A) with the estimated model-voltage drop of step C);
E) adjusting at least one model parameter of either the electrical model or the thermal model based on the result of step D); and
F) estimating a characteristic variable not measured in step A) as an estimation of a physical variable of the system during operation with the thermal and/or electrical model executed by the processing unit and based on the result of at least one of the steps A) to D).

Steps A) to D) and F) of the method according to the second aspect of the invention correspond to steps a) to d) and g) of the method according to the first aspect of the invention, so that for steps A) to D) and F) of the method according to the second aspect of the invention reference is made to the corresponding preceding explanations, preferred features, advantages and/or technical effects in an analogous manner as previously discussed for steps a) to d) and g) of the method according to the first aspect of the invention.

Step E) of the method according to the second aspect invention corresponds to either step e) or step f) of the method according to the first aspect of the invention, such that for step E) of the method according to the second aspect invention, reference is made to the corresponding preceding explanations, preferred features, advantages and/or technical effects in an analogous manner as discussed for either step e) or step f) of the method according to the first aspect of the invention.

The voltage drop measured in step A) is, for example, the on-state voltage drop or the gate-source voltage drop. The measured voltage drop is explained below (and above with reference to the first aspect of the invention) in connection with the on-state voltage drop, but the measured voltage drop is preferably not intended to be limited to the on-state voltage drop. The technical explanations, preferred features, technical effects or advantages given in connection with the on-state voltage drop as a preferred embodiment of the voltage drop measured in step A) may apply in an analogous manner to any further preferred embodiment of the voltage drop measured in step A), such as the measured gate-source voltage drop. Preferably, however, the voltage drop measured in step A) is assumed to be defined by the on-state voltage drop.

The model voltage drop estimated in step C) may be defined, for example, by an estimated voltage for the on-state voltage drop measured in step A) or by an estimated voltage for the gate-source voltage drop measured in step A). The estimated model voltage drop is explained below (and above with reference to the first aspect of the invention) in connection with the estimated model on-state voltage drop, but the estimated model voltage drop is preferably not intended to be limited to the estimated model on-state voltage drop. The technical explanations, preferred features, technical effects or advantages provided in connection with the on-state voltage drop as a preferred embodiment of the model voltage drop estimated in step c) may apply in an analogous manner to any further advantageous embodiment of the model voltage drop estimated in step C), such as the estimated model gate-source voltage drop. Preferably, however, the model voltage drop estimated in step C) is assumed to be defined by the estimated model gate-source voltage drop.

The method according to the second aspect of the invention thus preferably differs from the method according to the first aspect of the invention in that only one of steps e) or f) of the method according to the first aspect of the invention is carried out as step E) of the method according to the second aspect of the invention. This offers the advantage that only one of the two models needs to be adjusted by the method. In practice, it has been shown that a more stable and/or faster convergence of the associated model parameters can thereby be achieved, so that the respective model adjusted in step E) can better represent the respective actual technical properties of the electrical or electronic system. The respective other model, which is not necessarily adapted in step E) of the method according to the second aspect of the invention, may be predetermined and may also not be changed during the execution of the method according to the second aspect of the invention. For example, in an exemplary embodiment of step E) of the method according to the second aspect of the invention, only the at least one model parameter of the thermal model is adjusted based on the result from step D). Preferably, the electrical model and/or the model parameters of the electrical model are not changed. Rather, the electrical model and the associated model parameters may be predetermined. In step F), the characteristic variable that was not measured in step A) is determined or estimated based on the thermal model and/or the electrical model. For step F) it is preferably provided that the characteristic variable determined or estimated in step F) is determined and/or estimated at least with the model that was previously adjusted in step E). In addition, the model that has not been adapted in step E) may also be used. If the aforementioned example is taken up again, it is possible, for example, for step F) that the characteristic variable which was not measured in step A) is determined and/or estimated as an estimate for a physical variable of the system during its operation by executing the thermal model of the system adjusted in step E) and a predetermined electrical model of the system by means of the processing unit, taking into account the result of at least one of steps A) to D).

According to a preferred embodiment of the method according to the second aspect of the present invention, the parameters of the electrical model are predefined and/or pre-adjusted, and wherein the parameters of the electrical model remain unchanged during steps A) to F). As a result, in step E) may only the at least one model parameter of the thermal model be adjusted. As a further result, step E) may be specified as: adjusting at least one model parameter of the thermal model based on the result of step D). As an even further result, step F) may be specified as: estimating a characteristic variable not measured in step A) as an estimation of a physical variable of the system during operation with the adjusted thermal model, and preferably also with the predetermined electrical model, executed by the processing unit and based on the result of at least one of the steps A) to D).

According to a further preferred embodiment of the method according to the second aspect of the present invention, wherein the group of steps A) to F) is repeated groupwise during a first phase with adjusting the at least one model parameter of the electrical model in each step E) based on the result of previous step D), and wherein the group of steps A) to F) is repeated groupwise during a second phase with adjusting the at least one model parameter of the thermal model in each step E) based on the result of the previous step D), wherein the first phase is prior in time or subsequent in time to the second phase.

The group of steps A) to F) may thus first be carried out repeatedly in order to adjust the model parameters of the electrical model of the electrical or electronic system so that the electrical model represents the electrical properties of the system particularly well. Subsequently, the group of steps A) to F) can be executed repeatedly again, but not the model parameters of the electrical model, rather the model parameters of the thermal model of the electrical or electronic system are adjusted, so that thereupon not only the electrical model represents the electrical properties of the system particularly well, but also the thermal model represents the associated thermal properties of the system particularly well. The sequence mentioned, that first the electrical model and then the thermal model are adjusted, can also be carried out in the reverse order. In addition, it has been found to be advantageous if the group of steps A) to F) is replaced by the group of steps A) to E), with step F) being executed at least once at the end after the second pass of the repetition of the group of steps A) to E). This allows or may ensure that first both models, i.e. the electrical model and the thermal model are adjusted before step F) is executed. The result of step F) may then be very accurate.

According to a third aspect of the present invention, the problem outlined in the introduction is solved by a method according to claim 7. Therefore, a method for monitoring an electrical or electronic system is provided, wherein the method comprising at least the following first and second group of steps, wherein the first group of steps comprises the steps a) to f) and wherein the second group of steps comprises the steps A) to F):
a) measuring at least one characteristic variable of the system during operation of the system, wherein the at least one characteristic variable of the system includes a voltage drop, in particular an on-state voltage drop or a gate-source voltage drop, across two nodes of the system being connected directly or indirectly to a semiconductor device of the system;
b) estimating a thermal variable of the system with a thermal model of the system executed by a processing unit and based at least one measured variable of step a);
c) estimating a model-voltage drop, in particular an on-state model-voltage drop or a gate-source model-voltage drop, as an estimation for the measured voltage drop of step a) with an electrical model of the system executed by the processing unit and based at least on the estimated thermal variable of step b);
d) comparing the measured voltage drop of step a) with the estimated model-voltage drop of step c);
e) adjusting at least one model parameter of the thermal model based on the result of step d);
f) adjusting at least one model parameter of the electrical model based on the result of step d);

A) measuring the at least one characteristic variable of the system during operation of the system, wherein the at least one characteristic variable of the system includes the voltage drop, in particular the on-state voltage drop or the gate-source voltage drop, across two nodes of the system being connected directly or indirectly to the semiconductor device of the system;
B) estimating the thermal variable of the system with the adjusted thermal model of the system executed by a processing unit and based at least one measured variable of step A);
C) estimating a model-voltage drop, in particular an on-state model-voltage drop or a gate-source model-voltage drop, as an estimation for the measured voltage drop of step A) with the adjusted electrical model of the system executed by the processing unit and based at least on the estimated thermal variable of step B);
D) comparing the measured voltage drop of step A) with the estimated on-state model-voltage drop of step C);
E) adjusting at least one model parameter of either the electrical model or the thermal model based on the result of step D); and
F) estimating a characteristic variable not measured in step A) as an estimation of a physical variable of the system during operation with the thermal and/or electrical model executed by the processing unit and based on the result of at least one of the steps A) to D).

Steps a) to f) of the method according to the third aspect of the invention correspond to steps a) to f) of the method according to the first aspect of the invention, so that for steps a) to f) of the method according to the third aspect of the invention reference is made to the corresponding preceding explanations, preferred features, advantages and/or technical effects in an analogous manner as previously discussed for steps a) to f) of the method according to the first aspect of the invention.

Steps A) to F) of the method according to the third aspect of the invention correspond to steps A) to F) of the method according to the second aspect of the invention, so that for steps A) to F) of the method according to the third aspect of the invention reference is made to the corresponding preceding explanations, preferred features, advantages and/or technical effects in an analogous manner as previously discussed for steps A) to F) of the method according to the second aspect of the invention.

Preferably, the second group of steps is performed after the first group of steps is performed.

With respect to step B), it should be noted that the thermal model has already been previously adjusted in step d) of the first group of steps. Against this background, in step B), reference is made to the thermal model already adjusted.

With respect to step C), it should be noted that the electrical model has already been previously adjusted in step f) of the first group of steps. Against this background, in step C) reference is made to the already adjusted electrical model.

In principle, the same characteristic variable(s) of the system are measured in steps a) and A), however they are measured at different points in time.

The method according to the third aspect offers the advantage that by the first group of steps first both models are improved, and that subsequently by the second group of steps only one of the two models, preferably the thermal model, is improved in step E), so that preferably a robust and fast convergence of the model parameters of the thermal model is achievable.

Furthermore, in the second group of steps in step F), the characteristic variable is determined or estimated, which was not previously measured in step A). For the determination of the characteristic variable according to step F), preferably both models, i.e. the thermal model and the electrical model are executed by the processing unit. At least the electrical model has already been improved by the first group of steps. Furthermore, the thermal model has already been improved by the first group of steps. However, further improvement of the thermal model is performed by the second group of steps. Therefore, in step F), the thermal model and the electrical model can be understood as the adjusted thermal model and adjusted electrical model, respectively. As a result, the characteristic variable determined or estimated in step F) represents a particularly accurate estimate of the actual physical variable of the system.

According to a preferred embodiment of the method according to the third aspect of the present invention, wherein the first group is repeated one after the other, wherein the parameters of the thermal and electrical model are set by predetermined parameters at the first execution of the steps b) and c) of the first group of features, and wherein the parameters of the thermal and electrical model used in steps b) and c) for each subsequent repetition of the first group of steps are set by the model parameters adjusted in the previous execution of the first group at a repetition of the first group of steps.

This embodiment offers the advantage that both models, i.e. the thermal model and the electrical model, are initially improved by repeating the first group of steps, and that subsequently, in the second group of steps, one of the two models is additionally improved even further. This embodiment has turned out to be advantageous in particular if in the second group in the steps, in particular in the associated step E) the model parameters of the thermal model are adjusted based on the respective previous step D).

According to a further preferred embodiment of the method according to the third aspect of the present invention, the first group of steps is executed repeatedly before the second group of steps is first executed.

According to a further preferred embodiment of the method according to the third aspect of the present invention, the first group of steps is repeated until the result of step d) is less than a predetermined threshold. This allows the method as a whole to be carried out particularly efficiently. Thus, it can also be achieved that at least both models, i.e. the thermal model and the electrical model, provide a certain minimum quality with respect to the representation of the thermal and electrical properties of the system.

According to a further preferred embodiment of the method according to the third aspect of the present invention, the model parameters of either the thermal model or the electrical model are adjusted in the second group of steps only, wherein the model parameters of the other model remain unchanged during the second group of steps. This also allows the method as a whole to be carried out particularly efficiently. As previously mentioned, this can also allow the model adjusted in step E) to converge, thereby achieving a particularly accurate result in step F).

According to a further preferred embodiment of the method according to the third aspect of the present invention, the second group is repeated one after the other, wherein the model parameters of the thermal and electrical model are set by model parameters adjusted last in the first group of steps for the steps B) and C) at the first execution second group of steps, and wherein the model parameters of either the thermal model or the electrical model for each subsequent repetition of the second group of steps are set by the model parameters adjusted in the previous execution of the second group of steps.

Thus, in the first execution of the second group of steps, the model parameters for the thermal model maybe determined by the model parameters of the thermal model last adjusted in step e) of the first group of steps. Furthermore, when the second group of steps is executed for the first time, the model parameters of the electrical model may be determined by the model parameters of the electrical model last adjusted in step f) of the first group of steps. If the second group of steps is repeated, in each repetition in the associated step E) the model parameters of either the electrical model or the thermal model may be further adjusted based on the previous result from step D). For the other (unadjusted) model, the associated model parameters remain unchanged. In this way, convergence of the model adjusted in the respective step E) can be achieved, so that the characteristic variable determined or estimated in step F) can represent the associated physical variable of the system particularly accurately.

According to a further preferred embodiment of the method according to the first, second and/or third aspect of the present invention, the at least one characteristic variable of the system measured in step a) and/or A) also comprises at least one of the following characteristic variables of the system:
- an on-state current of the semiconductor device of the system,
- off-state voltage of the semiconductor device of the system,
- a total on-state duration of the semiconductor device of the system, preferably within a measurement interval of step a) or A), respectively, and/or a tick period for the semiconductor device,
- a switching frequency of the semiconductor device, and
- a reference temperature of the semiconductor device of the system.

According to a further preferred embodiment of the method according to the first, second and/or third aspect of the present invention, each characteristic variable of the system measured in step a) and/or A) is an externally measurable characteristic variable of the system.

According to a further preferred embodiment of the method according to the first, second and/or third aspect of the present invention, the at least one characteristic variable of the system estimated in step g) and/or F) estimates at least one of the following characteristic variables of the system:
- a junction temperature of the semiconductor device of the system,
- an electrical and/or thermal power loss of the semiconductor device of the system,
- a gate threshold voltage of the semiconductor device of the system,
- a gate voltage of the semiconductor device of the system during switching of the semiconductor device, and
- an internal gate resistance of the semiconductor device of the system,

According to a further preferred embodiment of the method according to the first, second and/or third aspect of the present invention, each characteristic variable of the system estimated in step g) and/or F) is an internal, preferably not externally measurable characteristic variable of the system. As a result, the at least one characteristic variable of the system estimated in step g) and/or F) may comprise at least one of the following characteristic variables of the system:
- a junction temperature of the semiconductor device of the system,
- an electrical and/or thermal power loss of the semiconductor device of the system, Thus, in step g) and/or step F), a characteristic variable representing a non-measurable physical variable of the system may be determined or estimated. Such physical non-measurable variables may be particularly advantageously used to monitor and/or determine the lifetime, reliability, or other characteristics of the electrical or electronic system. The processing unit maybe configured for this purpose, in particular to determine and/or monitor the lifetime and/or reliability of the electrical or electronic system.

According to a fourth aspect of the present invention, the problem outlined in the introduction is solved by a system according to claim 17. This system maybe referred to as the main system or entire system. This main system comprises a power semiconductor device, a processing unit and a measuring unit, wherein the measuring unit is configured to measure at least one characteristic variable of the system during operation of the system according to step a) and/or A), and wherein the processing unit is configured to execute steps b) to g) of the first aspect of the present invention, steps b) to F) of the second aspect of the present invention and/or steps b) to f) and B) to F) of the third aspect of the present invention.

According to a preferred embodiment of the main system according to the fourth aspect of the present invention, the main system comprises a power converter, which includes the semiconductor device as a power semiconductor device.

Further features, advantages and application possibilities of the present invention may be derived from the following description of exemplary embodiments and/or the figures. Thereby, all described and/or visually depicted features for themselves and/or in any combination may form an advantageous subject matter and/or features of the present invention independent of the combination in the individual claims or the dependencies. Furthermore, in the figures, same reference signs may indicate same or similar objects.
Fig. 1 schematically illustrates embodiment of a flow chart of the method according the first aspect of the present invention.
Fig. 2 schematically illustrates an embodiment of a flow chart of the method according the second aspect of the present invention.
Fig. 3 schematically illustrates an embodiment of a flow chart of the method according the third aspect of the present invention.
Fig. 4 schematically illustrates an advantageous representation of the functional relationships underlying the methods of the invention.
Fig. 5 schematically illustrates an embodiment of the system according the fourth aspect of the present invention.

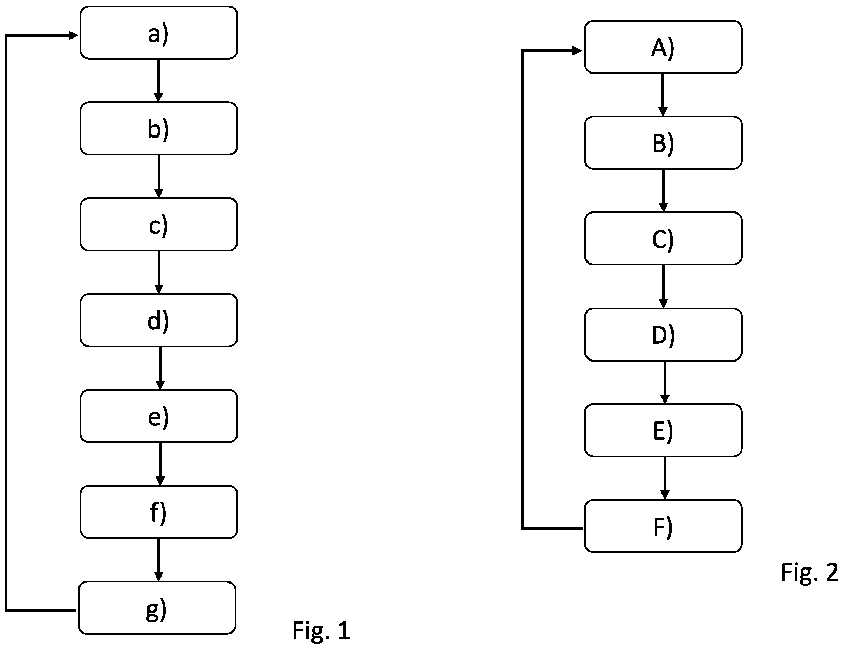

Figure 1 schematically illustrates an embodiment of a flow chart of the method for monitoring an electrical or electronic system 30 according the first aspect of the present invention. The method according to the first aspect of the present invention comprises the following steps a) to g):
a) measuring at least one characteristic variable of the system (30) during operation of the system (30), wherein the at least one characteristic variable of the system (30) includes an on-state voltage drop Vce(on) across two nodes of the system (30) being connected directly or indirectly to a semiconductor device of the system (30);
b) estimating a thermal variable Tj-r of the system (30) with a thermal model (24) of the system (30) executed by a processing unit (32) and based on at least one measured characteristic variable of step a);
c) estimating an on-state model-voltage drop Vce(on),pre as an estimation for the measured on-state voltage drop Vce(on) of step a) with an electrical model (26) of the system (30) executed by the processing unit (32) and based at least on the estimated thermal variable Tj-r of step b);
d) comparing the measured on-state voltage drop Vce(on) of step a) with the estimated on-state model-voltage drop Vce(on),pre of step c);
e) adjusting at least one model parameter of the thermal model (24) based on the result of step d);
f) adjusting at least one model parameter of the electrical model (26) based on the result of step d); and
g) estimating a characteristic variable Tj,est not measured in step a) as an estimation of a physical variable Tj of the system (30) during operation with the adjusted, thermal and/or electrical model (24, 26) executed by the processing unit (32) and based on the result of at least one of the steps a) to d).

Figure 2 schematically illustrates an embodiment of a flow chart of the method for monitoring an electrical or electronic system 30 according the second aspect of the present invention. The method according to the second aspect of the present invention comprises the following steps A) to F):
A) measuring at least one characteristic variable of the system (30) during operation of the system (30), wherein the at least one characteristic variable of the system (30) includes an on-state voltage drop Vce(on) across two nodes of the system (30) being connected directly or indirectly to a semiconductor device of the system (30);
B) estimating a thermal variable Tj-r of the system (30) with a thermal model (24) of the system (30) executed by a processing unit (32) and based at least one measured variable of step A);
C) estimating an on-state model-voltage drop Vce(on),pre as an estimation for the measured on-state voltage drop Vce(on) of step A) with an electrical model (26) of the system (30) executed by the processing unit (32) and based at least on the estimated thermal variable Tj-r of step B);
D) comparing the measured on-state voltage drop Vce(on) of step A) with the estimated on-state model-voltage drop Vce(on),pre of step C);
E) adjusting at least one model parameter of either the electrical model (26) or the thermal model (24) based on the result of step D); and
F) estimating a characteristic variable Tj,est not measured in step A) as an estimation of a physical variable Tj of the system (30) during operation with the thermal and/or electrical model (24, 26) executed by the processing unit (32) and based on the result of at least one of the steps A) to D).

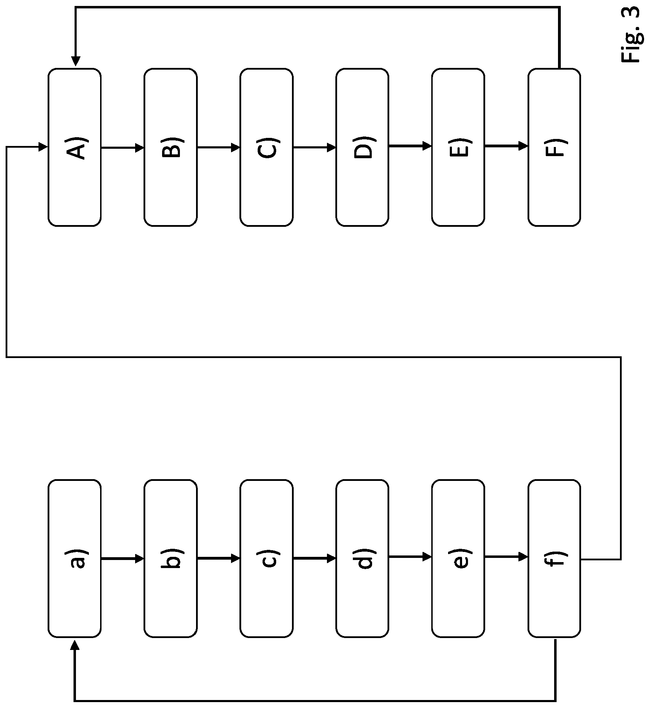

Figure 3 schematically illustrates an embodiment of a flow chart of the method for monitoring an electrical or electronic system 30 according the third aspect of the present invention. The method according to the third aspect of the present invention comprises a first group of steps and a second group of steps, wherein the first group of steps comprises the steps a) to f) and wherein the second group of steps comprises the steps A) to F):
a) measuring at least one characteristic variable of the system (30) during operation of the system (30), wherein the at least one characteristic variable of the system (30) includes an on-state voltage drop Vce(on) across two nodes of the system (30) being connected directly or indirectly to a semiconductor device of the system (30);
b) estimating a thermal variable Tj-r of the system (30) with a thermal model (24) of the system (30) executed by a processing unit (32) and based at least one measured variable of step a);
c) estimating an on-state model-voltage drop Vce(on),pre as an estimation for the measured on-state voltage drop Vce(on) of step a) with an electrical model (26) of the system (30) executed by the processing unit (32) and based at least on the estimated thermal variable Tj-r of step b);
d) comparing the measured on-state voltage drop Vce(on) of step a) with the estimated on-state model-voltage drop Vce(on),pre of step c);
e) adjusting at least one model parameter of the thermal model (24) based on the result of step d); and
f) adjusting at least one model parameter of the electrical model (26) based on the result of step d);

A) measuring the at least one characteristic variable of the system (30) during operation of the system (30), wherein the at least one characteristic variable of the system (30) includes the on-state voltage drop Vce(on) across two nodes of the system (30) being connected directly or indirectly to the semiconductor device of the system (30);
B) estimating the thermal variable Tj-r of the system (30) with the adjusted thermal model (24) of the system (30) executed by a processing unit (32) and based at least one measured variable of step A);
C) estimating an on-state model-voltage drop Vce(on),pre as an estimation for the measured on-state voltage drop Vce(on) of step A) with the adjusted electrical model (26) of the system (30) executed by the processing unit (32) and based at least on the estimated thermal variable Tj-r of step B);
D) comparing the measured on-state voltage drop Vce(on) of step A) with the estimated on-state model-voltage drop Vce(on),pre of step C);
E) adjusting at least one model parameter of either the electrical model (26) or the thermal model (24) based on the result of step D); and
F) estimating a characteristic variable Tj,est not measured in step A) as an estimation of a physical variable Tj of the system (30) during operation with the thermal and/or electrical model (24, 26) executed by the processing unit (32) and based on the result of at least one of the steps A) to D).

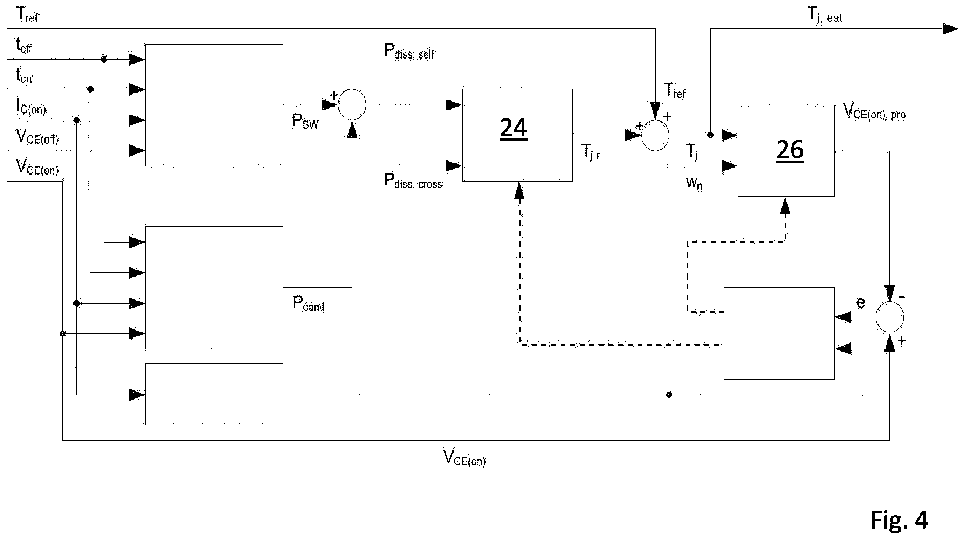

Figure 4 schematically illustrates an advantageous representation of the functional relationships underlying the methods according to each of the first to third aspect of the present invention.

In the shown exemplary and non-limiting case of Figure 4, the electric or electronic system 30 comprises a power converter with a power semiconductor device. The following discussion with respect to Figure 4, however, applies analogously for other types of electric or electronic systems.

During the operation of the power converter 30, one or more characteristic variable of the system are measured in step a) of the first and/or third aspect of the present invention and/or according to step A) of the method according the second and/or third aspect of the present invention. It is to be noted, that among the measured characteristic variables, at least the on-state voltage drop Vce(on) of the power semiconductor device of the power converter (as an example of the electric or electronic system) is measured.

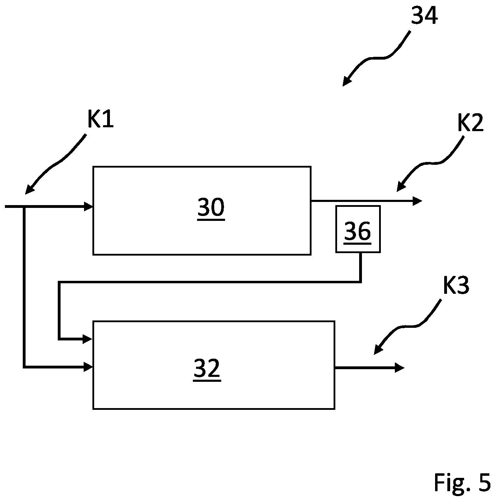

In the shown example of Figure 4, also a reference temperature Tref of the power converter and plurality of electrical variable of the power converter including a total off-state duration toff of the power semiconductor device of the converter, a total on-state duration ton of the power semiconductor device of the power converter, an on-state current Ion of the power semiconductor device of the power converter, an off-state voltage Voff of the power semiconductor device of the power converter is measured as characteristic variables of the converter 30, being an example of the electric or electronic system 30, which is schematically illustrated in Figure 5.

Figure 5 schematically illustrates an advantageous embodiment of the main system 34 according to the fourth aspect of the invention. The main system 34 comprises the electrical or electronic system 30, which is preferably designed as a converter 30, a measuring unit 36 and a processor unit 32. Thus, the electrical or electronic system 30 may form a sub-system of the main system 34.

Technical signals or variables which enter the electrical or electronic system 30 as input variables are summarized in Figure 5 with the reference sign K1. Measurable variables, in particular measurable output variables of the electrical or electronic system 30 (preferably the converter 30) are designated in Figure 5 by the reference sign K2.

As can be seen from Figure 5 by way of example, the measuring unit 36 can be arranged and/or designed to measure at least one output variable K2 of the system 30 or of the converter 30. The measuring unit 36 is coupled to the processor unit 32 to transmit the measured, at least one output variable K2 to the processor unit 32. It is also preferred that at least one of the input variable one is transmitted to the processor unit 32.

Referring again to Figure 4, the processor unit 32 is preferably configured to determine switching power loss Psw is determined from the on- and off-state durations ton, toff, the on-state current Ion, the switching frequency and the off-state voltage Voff.

The processor unit 32 may also be configured to determine a conduction power loss Pcond from the on- and off-state durations ton, toff, the on-state current Ion, and the measured on-state voltage drop Vce(on).

The processor unit 32 may also be configured to add up the conduction power loss Pcond and the switching power PSW loss and the resulting power sum Pdiss,self may be used as an input for a thermal model 24 of the electrical or electronic system 30, in particular the converter 30.

The power sum Pdiss,self corresponds to a power dissipation due to self-heating of the power semiconductor device of the converter 30. Optionally, a cross-coupling power dissipation Pdiss,cross due to further devices of the converter 30, which may affect the junction temperature Tj of the power semiconductor device of the converter 30 may be determined by the processing unit 32 and used as an additional input to the thermal model 24.

When the thermal model 24 is executed by the processor unit 32 in step b) of the first and/or third aspect of the present invention and/or in step B) of the second and/or third aspect of the present invention, an output of the thermal model 24 may represent a temperature difference Tj-r between the junction temperature Tj of the semiconductor device of the converter 30 and the reference temperature Tref, which may for example be a baseplate temperature or a temperature of an internal thermistor of the of the converter 30. Therefore, the reference temperature Tref may be fed to the output of the thermal model 24, resulting in an estimate for the junction temperature Tj.

The processor unit 32 may also be configured to use the estimated junction temperature Tj as an input to an electrical model 26 of the electric or electronic system 30, preferably formed by the converter 30.

When the electrical model 26 is executed by the processor unit 32 in step c) of the first and/or third aspect of the present invention and/or in step C) of the second and/or third aspect of the present invention, an output of the electrical model 26 represents at least an estimated on-state voltage drop Vce(on),pre as an estimation for the measured on-state voltage drop Vce(on). The output of the executed electrical model 26 may also represent estimations for other characteristic variables of the electric or electronic system 30, preferably formed by the converter 30. The further one or more estimated characteristic variables may related to at least one of a gate threshold voltage of the semiconductor device, an internal gate resistance of the semiconductor device and/or a characteristic switching parameter of the semiconductor device.

The thermal model of the electric or electronic system 30, preferably formed by the converter 30, may be configured to represent the functional relationship, that in a steady state of the semiconductor device, a rate of change of the junction temperature Tj may be equal to a rate of change of the reference temperature Tb for a constant power dissipation. Therefore, the junction temperature Tj may follow the reference temperature Tb with an offset. The offset may correspond to a respective thermal resistance multiplied by the constant power dissipation. Furthermore, also the measured on-state voltage drop Vce(on) may follow the rate of temperature change, albeit with a scale factor.

The processor unit 32 may also be configured to compare the measured on-state voltage drop Vce(on) with the estimated on-state voltage drop Vce(on),pre resulting in a voltage drop error e according to step d) of the first and/or third aspect of the present invention and/or in step D) of the second and/or third aspect of the present invention.

Furthermore, the processor unit 32 may also be configured to adjust at least one model parameter of the thermal model 24 based on the voltage drop error e according to step e) of the first and/or third aspect of the present invention and/or in step E) of the second and/or third aspect of the present invention.

Moreover, the processor unit 32 may also be configured to adjust at least one model parameter of the electrical model 26 based on the voltage drop error e according to step f) of the first and/or third aspect of the present invention and/or in step E) of the second and/or third aspect of the present invention.

In case the voltage drop error e is sufficiently small, for example all lie below respective threshold values, the processing unit 32 may skip the adjustment of the thermal model 24 and/or electrical model 26 or, alternatively, adjust at least one of the thermal and electrical model 24, 26 a final time.

The processing unit 32 is also configured to estimate a characteristic variable not measured in step a) as an estimation of a physical variable of the electrical or electronic system 30, in particular the converter with the adjusted, thermal and/or electrical model 24, 26 executed by the processing unit. For instance, the processing unit 32 may be configured to estimate the temperature Tj,est as an estimation of the the junction temperature Tj of the semiconductor device of the converter 30.

It is additionally pointed out that "comprising" does not rule out other elements, and "a" or "an" does not rule out a multiplicity. It is also pointed out that features that have been described with reference to one of the above exemplary embodiments may also be disclosed as in combination with other features of other exemplary embodiments described above. Reference signs in the claims are not to be regarded as restrictive.

## Claims

1. **Method** for monitoring an electrical or electronic system (30), the method comprising the steps:
a) measuring at least one characteristic variable of the system (30) during operation of the system (30), wherein the at least one characteristic variable of the system (30) includes a voltage drop, in particular an on-state voltage drop Vce(on), across two nodes of the system (30) being connected directly or indirectly to a semiconductor device of the system (30);
b) estimating a thermal variable Tj-r of the system (30) with a thermal model (24) of the system (30) executed by a processing unit (32) and based on at least one measured characteristic variable of step a);
c) estimating a model-voltage drop, in particular an on-state model-voltage drop Vce(on),pre, as an estimation for the measured voltage drop of step a) with an electrical model (26) of the system (30) executed by the processing unit (32) and based at least on the estimated thermal variable Tj-r of step b);
d) comparing the measured voltage drop, in particular the measured on-state voltage drop Vce(on), of step a) with the estimated model-voltage drop, in particular the estimated on-state model-voltage drop Vce(on),pre, of step c);
e) adjusting at least one model parameter of the thermal model (24) based on the result of step d);
f) adjusting at least one model parameter of the electrical model (26) based on the result of step d); and
g) estimating a characteristic variable Tj,est not measured in step a) as an estimation of a physical variable Tj of the system (30) during operation with the adjusted, thermal and/or electrical model (24, 26) executed by the processing unit (32) and based on the result of at least one of the steps a) to d).

2. Method according to any of the preceding claims, wherein the semiconductor device of step a) is a transistor, a diode, or a thyristor.

3. Method according to any of the preceding claims, wherein a first group of steps includes steps a) to d) and e) and/or f) of claim 1, wherein the first group is repeated one after the other, wherein the model parameters of the thermal and electrical model (24, 26) are set by predetermined parameters at the first execution of the first group, and wherein the model parameters of the thermal and/or electrical model (24, 26) are set by the model parameters adjusted in the previous execution of the first group at a repetition of the first group.

4. **Method** for monitoring an electrical or electronic system (30), the method comprising the steps:
A) measuring at least one characteristic variable of the system (30) during operation of the system (30), wherein the at least one characteristic variable of the system (30) includes a voltage drop, in particular an on-state voltage drop Vce(on), across two nodes of the system (30) being connected directly or indirectly to a semiconductor device of the system (30);
B) estimating a thermal variable Tj-r of the system (30) with a thermal model (24) of the system (30) executed by a processing unit (32) and based at least one measured variable of step A);
C) estimating a model-voltage drop, in particular an on-state model-voltage drop Vce(on),pre, as an estimation for the measured voltage drop of step A) with an electrical model (26) of the system (30) executed by the processing unit (32) and based at least on the estimated thermal variable Tj-r of step B);
D) comparing the estimated voltage drop, in particular the measured on-state voltage drop Vce(on), of step A) with the estimated model-voltage drop, in particular the estimated on-state model-voltage drop Vce(on),pre, of step C);
E) adjusting at least one model parameter of either the electrical model (26) or the thermal model (24) based on the result of step D); and
F) estimating a characteristic variable Tj,est not measured in step A) as an estimation of a physical variable Tj of the system (30) during operation with the thermal and/or electrical model (24, 26) executed by the processing unit (32) and based on the result of at least one of the steps A) to D).

5. Method according to the preceding claim, wherein the parameters of the electrical model (26) are predefined and/or pre-adjusted, and wherein the parameters of the electrical model (26) remain unchanged during steps A) to F).

6. Method according to claim 4, wherein the group of steps A) to F) is repeated groupwise during a first phase with adjusting the at least one model parameter of the electrical model (26) in each step E) based on the result of previous step D), and wherein the group of steps A) to F) is repeated groupwise during a second phase with adjusting the at least one model parameter of the thermal model (24) in each step E) based on the result of the previous step D), wherein the first phase is prior in time or subsequent in time to the second phase.

7. **Method** for monitoring an electrical or electronic system (30),
the method comprising a first group of steps:
a) measuring at least one characteristic variable of the system (30) during operation of the system (30), wherein the at least one characteristic variable of the system (30) includes a voltage drop, in particular an on-state voltage drop Vce(on), across two nodes of the system (30) being connected directly or indirectly to a semiconductor device of the system (30);
b) estimating a thermal variable Tj -r of the system (30) with a thermal model (24) of the system (30) executed by a processing unit (32) and based at least one measured variable of step a);
c) estimating a model-voltage drop, in particular an on-state model-voltage drop Vce(on),pre, as an estimation for the measured voltage drop of step a) with an electrical model (26) of the system (30) executed by the processing unit (32) and based at least on the estimated thermal variable Tj-r of step b);
d) comparing the measured voltage drop, in particular the measured on-state voltage drop Vce(on), of step a) with the estimated model-voltage drop, in particular the estimated on-state model-voltage drop Vce(on),pre, of step c);
e) adjusting at least one model parameter of the thermal model (24) based on the result of step d); and
f) adjusting at least one model parameter of the electrical model (26) based on the result of step d),
wherein the method further comprises a second group of steps:
A) measuring the at least one characteristic variable of the system (30) during operation of the system (30), wherein the at least one characteristic variable of the system (30) includes a voltage drop, in particular the on-state voltage drop Vce(on), across two nodes of the system (30) being connected directly or indirectly to the semiconductor device of the system (30);
B) estimating the thermal variable Tj-r of the system (30) with the adjusted thermal model (24) of the system (30) executed by a processing unit (32) and based at least one measured variable of step A);
C) estimating a model-voltage drop, in particular an on-state model-voltage drop Vce(on),pre, as an estimation for the measured voltage drop of step A) with the adjusted electrical model (26) of the system (30) executed by the processing unit (32) and based at least on the estimated thermal variable Tj-r of step B);
D) comparing the measured voltage drop, in particular the measured on-state voltage drop Vce(on), of step A) with the estimated voltage drop, in particular the estimated on-state model-voltage drop Vce(on),pre, of step C);
E) adjusting at least one model parameter of either the electrical model (26) or the thermal model (24) based on the result of step D); and
F) estimating a characteristic variable Tj,est not measured in step A) as an estimation of a physical variable Tj of the system (30) during operation with the thermal and/or electrical model (26) executed by the processing unit (32) and based on the result of at least one of the steps A) to D).

8. Method according to the preceding claim, wherein the first group is repeated one after the other, wherein the parameters of the thermal and electrical model (26) are set by predetermined parameters at the first execution of the steps b) and c) of the first group of features, and wherein the parameters of the thermal and electrical model (26) used in steps b) and c) for each subsequent repetition of the first group of steps are set by the model parameters adjusted in the previous execution of the first group at a repetition of the first group of steps.

9. Method according to any of the preceding claims 7 to 8, wherein the first group of steps is executed repeatedly before the second group of steps is first executed.

10. Method according to any of the preceding claims 7 to 9, wherein the first group of steps is repeated until the result of step d) is less than a predetermined threshold.

11. Method according to the preceding claim 7 to 10, wherein the model parameters of either the thermal model (24) or the electrical model (26) are adjusted in the second group of steps only, wherein the model parameters of the other model remain unchanged during the second group of steps.

12. Method according to any of the preceding claims 7 to 11, wherein the second group is repeated one after the other, wherein the model parameters of the thermal and electrical model (24, 26) are set by model parameters adjusted last in the first group of steps for the steps B) and C) at the first execution second group of steps, and wherein the model parameters of either the thermal model (24) or the electrical model (26) for each subsequent repetition of the second group of steps are set by the model parameters adjusted in the previous execution of the second group of steps.

13. Method according to any of the preceding claims, wherein the at least one characteristic variable of the system (30) measured in step a) and/or A) also comprises at least one of the following characteristic variables of the system (30):
an on-state current Ic(on) of the semiconductor device of the system (30),
off-state voltage Vce(off) of the semiconductor device of the system (30),
a total on-state duration ton of the semiconductor device of the system (30), preferably within a measurement interval of step a) or A), respectively, and/or a tick period for the semiconductor device,
a switching frequency of the semiconductor device, and
a reference temperature Tref of the semiconductor device of the system (30).

14. Method according to any of the preceding claims, wherein each characteristic variable of the system (30) measured in step a) and/or A) is an externally measurable characteristic variable of the system (30).

15. Method according to any of the preceding claims, wherein the at least one characteristic variable of the system (30) estimated in step g) and/or F) estimates at least one of the following characteristic variables of the system (30):
a junction temperature Tj of the semiconductor device of the system (30),
an electrical and/or thermal power loss (Psw, Pcond) of the semiconductor device of the system (30),
a gate threshold voltage of the semiconductor device of the system (30),
a gate voltage of the semiconductor device of the system (30) during switching of the semiconductor device, and
an internal gate resistance of the semiconductor device of the system (30),

16. Method according to any of the preceding claims, wherein each characteristic variable of the system (30) estimated in step g) and/or F) is an internal, preferably not externally measurable characteristic variable of the system (30).

17. **Main system (34),** comprising:
a power semiconductor device
a processing unit (32),
a measuring unit (36),
wherein the measuring unit (36) is configured to measure at least one characteristic variable of the system (30) during operation of the system (30) according to step a) and/or A),
wherein the processing unit (32) is configured to execute steps b) to g) of one of the claims 1 to 3 and 13 to 16, steps B) to F) of one of the claims 4 to 6 and 13 to 16, and/or steps b) to f) and steps B) to F) of one of the claims 7 to 16.

18. Main system (34) according to the preceding claim, wherein the main system (34) comprises a power converter, which includes the semiconductor device as a power semiconductor device.
